# EUROPEAN PATENT APPLICATION

(11) **EP 2 280 044 A1**
(43) Date of publication of application: **02.02.2011**
(21) Application number: 09750427.8
(22) Date of filing: 31.03.2009
(51) Int. Cl.: C08L 63/00, C08G 59/42, C08K 7/18, H01L 23/29, H01L 23/31

(54) **EPOXY RESIN COMPOSITION FOR ENCAPSULATING ELECTRONIC PART**

(30) Priority: 21.05.2008 JP 2008133432
(71) Applicant: Nagase ChemteX Corporation, Osaka-shi, Osaka 550-8668 (JP)
(72) Inventor: KAN, Katsushi, Tatsuno-shi Hyogo 679-4124 (JP); OHORI, Tatsuya, Tatsuno-shi Hyogo 679-4124 (JP)
(74) Representative: Vossius & Partner
(86) International application number: PCT/JP2009/056602
(87) International publication number: WO 2009/142065

(57) **Abstract**

An epoxy resin composition for encapsulating electronic parts is provided which contains an inorganic filler in a large amount and which has a low viscosity and is flowable at ordinary temperature. The composition reconciles reactivity and storage stability, is excellent in suitability for demolding, molded-object appearance, etc., and is reduced in warpage. The epoxy resin composition comprises: (A) 100 parts by weight of an epoxy resin, (B) 50 to 150 parts by weight of an acid anhydride, and (C) 8 to 40 parts by weight of a curing accelerator of the microcapsule-type which satisfies the following: when 10 parts by weight of the curing accelerator is mixed with 100 parts by weight of the epoxy resin (A) and 100 parts by weight of a methyltetrahydroxy acid anhydride as the acid anhydride (B), the mixture has a viscosity increase ratio through 24 hours standing at 25°C of 1.0 to 2.0 times. The composition further contains (D) fused spherical silica having an average particle diameter of 20 to 40 µm in an amount of 88 to 92% by weight of the composition. The composition has a viscosity, as measured at 25°C under a shear rate of 2.5 (1/s), of 1000 Pa·s or lower.

## Description

### TECHNICAL FIELD

The present invention relates to an epoxy resin composition for encapsulating electronic parts, the composition containing a high content of an inorganic filler and being flowable at ordinary temperature.

### BACKGROUND ART

In recent years, the thickness of encapsulating resins has been reduced greatly with thinning of electronic parts, such as semiconductor packages. Encapsulation of electronic parts, such as semiconductors, has conventionally been carried out by a transfer molding method by using solid epoxy resin compositions. When a thin package is encapsulated with a resin by the transfer molding method, however, it is feared that wire deformation may occur because the resin is forced to flow into a narrow opening. Moreover, when an encapsulating area is enlarged, defective filling tends to occur more easily.

Therefore, a compression molding method using a liquid epoxy resin composition has recently come to be used for encapsulating a wafer-level PKG for encapsulating a thin film package or a large area. When a liquid epoxy resin composition is used for encapsulation-molding, it is expected that the composition hardly cause wire deformation and it will become possible to wholly encapsulate a large area because the viscosity in molding is very low as compared with a solid epoxy resin composition.

In wholly encapsulating a large area, however, there is a big problem of generation of warpage after molding. Hence, there is a technique to reduce thermal stress after molding by adding an inorganic filler in a large amount (see, for example, Patent Documents 1 to 3). When an inorganic filler is added in a large amount, however, the viscosity increases and the composition is no longer a liquid, so that wire sweep, which is a kind of wire deformation, or defective filling is easily caused or resin supply at the time of production becomes difficult. Therefore, regarding an epoxy resin composition for encapsulating electronic parts by a compression molding method, there has been a need for a liquid epoxy resin composition that contains an inorganic filler in a large amount, exhibits less warpage after molding, and has high flowability.

Patent Document 1: JP 8-41293 A
Patent Document 2: JP 2002-121260 A
Patent Document 3: JP 2007-19751 A

### DISCLOSURE OF THE INVENTION

### PROBLEMS TO BE SOLVED BY THE INVENTION

In view of the above-mentioned present situation, an object of the present invention is to provide an epoxy resin composition for encapsulating electronic parts, the composition containing an inorganic filler in a large amount, being low in viscosity and having flowability at ordinary temperature, and having the following advantages: reactivity and storage stability are reconciled, the epoxy resin composition is superior in, for example, mold releasability and appearance of molded articles, and is inhibited from generation of warpage.

### MEANS FOR SOLVING THE PROBLEMS

The present invention provides an epoxy resin composition for encapsulating electronic parts, comprising:
(A) 100 parts by weight of an epoxy resin,
(B) 50 to 150 parts by weight of an acid anhydride,
(C) 8 to 40 parts by weight of a curing accelerator of the microcapsule-type which satisfies the following: the viscosity increase ratio after 24 hours standing at 25°C of a mixture of 10 parts by weight of the curing accelerator, 100 parts by weight of the epoxy resin (A), and 100 parts by weight of methyltetrahydroxy acid anhydride as the acid anhydride (B) is 1.0 to 2.0 times, and
(D) fused spherical silica with an average particle diameter of 20 to 40 µm in an amount of 88 to 92% by weight of the composition, wherein
the viscosity of the composition at 25°C under a shear rate of 2.5 (1/s) is 1000 Pa·s or lower.

In one embodiment of the epoxy resin composition of the present invention, the fused spherical silica (D) with an average particle diameter of 20 to 40 µm contains fused spherical silica with an average particle diameter of 0.2 to 5 µm in an amount of 5 to 40% by weight.
In another embodiment of the epoxy resin composition of the present invention, the composition further contains (E) silicone gel or silicone oil in an amount of 5 to 100 parts by weight relative to 100 parts by weight of the epoxy resin (A), and (F) a dispersing agent.
In still another embodiment of the epoxy resin composition of the present invention, the dispersing agent (F) is an organopolysiloxane derivative having in its molecule a structure represented by the following formula (1).

-[-B-A-B-(C-D)n-C-]p- (1)

In the formula (1), A represents a residue of an organopolysiloxane compound that has active hydrogen-containing groups at both ends and has 20 to 50 siloxane bonds, B represents a residue of a bifunctional organic compound that has two functional groups capable of reacting with active hydrogen wherein the compound is selected from among a biphenyl or naphthalene skeleton-containing epoxy compound, a diisocyanate compound and a dicarboxylic acid compound, C represents a residue of a bifunctional organic compound that has two active hydrogen-containing groups wherein the residue is a residue of a bisphenol compound capable of reacting with an epoxy compound, a residue of a glycol compound capable of reacting with a diisocyanate compound, or a residue of a diamino compound capable of reacting with a dicarboxylic acid compound, D represents a residue of a bifunctional organic compound that has two functional groups capable of reacting with active hydrogen, n represents an integer of 1 to 20, and p represents an integer of 1 to 20.

### EFFECT OF THE INVENTION

Because of the above-mentioned configuration, the composition of the present invention has sufficient reactivity at high temperatures and, moreover, is inhibited from increasing in viscosity at room temperature. Because the composition has low tendency to increase in viscosity at room temperature, it exhibits less increase in viscosity during machine press for curing, so that the appearance of molded articles made therefrom will be good and it therefore is suitable for compression molding applications.
Moreover, because the composition has a sufficiently high Tg, for example, a Tg that is equal to or higher than the molding temperature after compression molding, the composition is of good mold releasability.
Furthermore, the composition of the present invention exhibits a low viscosity at ordinary temperature while being highly filled with an inorganic filler in an amount of 88 to 92% by weight, so that the composition will generate no warpage even if electronic parts in a thin package or electronic parts with a large area are encapsulated with the composition by compression molding and will cause neither wire sweep nor defective filling. Because of this, encapsulation of electronic parts, such as large-area semiconductor packages, can be performed with the composition with high productivity and high quality.
Moreover, by blending silicone gel or silicone oil together with a suitable dispersing agent, electronic parts with a larger area can be sealed successfully; for example, the composition of the present invention can be applied suitably also to encapsulating by compression molding of large-area electronic parts such as silicon wafers.

### BEST MODES FOR CARRYING OUT THE INVENTION

As the epoxy resin (A) in the present invention can be used epoxy resins to be used for semiconductor encapsulation. Examples thereof include mononucleus aromatic epoxy resins having one benzene ring, such as catechol diglycidyl ether, resorcin diglycidyl ether, phthalic acid diglycidyl ether, 2,5-diisopropylhydroquinone diglycidyl ether, hydroquinone diglycidyl ether, and phloroglucinol PEG; alicyclic epoxy resins; bisphenol type epoxy resins such as bisphenol A type, bisphenol F type, bisphenol AD type, and bisphenol S type, as well as oligomer mixtures obtained by partial condensation of bisphenol type epoxy resins, and nuclear hydrogenated epoxy resins of bisphenol type epoxy resins; tetramethylbis(4-hydroxyphenyl)methane diglycidyl ether and tetramethylbis(4-hydroxyphenyl) ether diglycidyl ether; biphenyl type or tetramethylbiphenyl type epoxy resins and nuclear hydrogenated epoxy resins thereof; fluorene type epoxy resins, such as bisphenol fluorene type epoxy resins, biscresolfluorene type epoxy resins, and BPEF diglycidyl ether; and naphthalene type epoxy resins. Moreover, from the viewpoint of elastic modulus, with these bifunctional epoxy resins can be combined polyfunctional epoxy resins having three or more functionalities. Examples of the polyfunctional epoxy resins include polyfunctional glycidylamines, dicyclopentadiene type epoxy resins, and polyfunctional glycidyl ethers. Moreover, it is also permissible to use in combination with other epoxy resins, for example, silylated epoxy resins, heterocyclic epoxy resins, diglycidyl ethers of bisphenol A propylene oxide adducts, diglycidyl ethers of bisphenol A ethylene oxide adducts, and diallylbisphenol A type epoxy resins. Preferred among these are bisphenol A type epoxy resins, alicyclic epoxy resins, naphthalene type epoxy resins, and combinations of two or more of them.

In the present invention, an acid anhydride that has been used as a curing agent for an epoxy resin can be used as the acid anhydride (B), and examples thereof include phthalic anhydride, tetrahydrophthalic anhydride, 3-methyltetrahydrophthalic anhydride, himic anhydride, methyltetrahydroxy acid anhydride, methylhexahydroxy acid anhydride, succinic anhydride, trimellitic anhydride, and pyromellitic anhydride. These may be used singly and also may be used in a combination of two or more of them. Preferred among these are methyltetrahydroxyacid anhydride and methylhexahydroxyacid anhydride.

In the present invention, used as the curing accelerator (C) is a microcapsule type curing accelerator which satisfies that the viscosity increase ratio after 24 hours standing at 25°C of a mixture of 10 parts by weight of the curing accelerator, 100 parts by weight of the epoxy resin (A), and 100 parts by weight of methyltetrahydroxy acid anhydride as the acid anhydride (B) is 1.0 to 2.0 times. The viscosity increase ratio is preferably 1.0 to 1.5 times. The smaller the viscosity increase ratio, the longer the handling time at the time of work can be made. If the viscosity increase ratio exceeds 2.0 times, no resin may be filled into some part of a cavity because the handleability at the time of work falls due to poor storage stability or the reactivity is high. Measurement of the viscosity increase ratio can be performed at 25°C by using an HBT type viscometer manufactured by Brookfield Engineering Labs, Inc. In the present invention, as the microcapsule type curing accelerator to be used as the curing accelerator (C) can be easily selected a proper one by measuring the viscosity increase ratio of a mixture of an epoxy resin, an acid anhydride, and a curing accelerator under the above-mentioned condition.

As the microcapsule type curing accelerator, examples which can be used include a fine particle composition obtained by dispersing an amine compound powder in an epoxy resin, for example. The amine compound may be selected, on the basis of a viscosity increase ratio, from among compounds provided below as examples: aliphatic primary amines, alicyclic primary amines, aromatic primary amines, aliphatic secondary amines, alicyclic secondary amines, aromatic secondary amines, imidazole compounds, imidazoline compounds, and reaction products of these compounds with carboxylic acids, sulfonic acids, isocyanates, epoxy, and so on. These may be used singly or alternatively two or more of them may be used in combination. For example, an aliphatic primary amine, an alicyclic primary amine, an aromatic primary amine, an aliphatic secondary amine, an alicyclic secondary amine, an aromatic secondary amine, an imidazole compound, or an imidazoline compound in combination with a reaction product of these compounds with a carboxylic acid, a sulfonic acid, an isocyanate or an epoxy can be used preferably. The volume average particle diameter of the amine compound powder is preferably 50 µm or less, more preferably 10 µm or less. Moreover, the melting point or softening point of the amine compound powder is preferably 60°C or higher from the viewpoint of inhibiting increase in viscosity at 25°C.

In the present invention, the incorporated amounts of these components are 50 to 150 parts by weight for the acid anhydride (B) and 8 to 40 parts by weight for the curing accelerator (C), respectively, relative to 100 parts by weight of the epoxy resin (A). When the content of the acid anhydride (B) is within the above-mentioned range, the curability and the physical properties of a cured material are good. If the content of the curing accelerator (C) is less than the above-mentioned range, a Tg after molding will not become sufficiently high, resulting in poor mold releasability, whereas if it exceeds the above-mentioned range, the fillability will be poor. Preferably, the content of the acid anhydride (B) is 80 to 120 parts by weight and that of the curing accelerator (C) is 10 to 25 parts by weight relative to 100 parts by weight of the epoxy resin (A).

In the present invention, furthermore, fused spherical silica (D) is contained in an amount of 88 to 92% by weight in the composition. As for the fused spherical silica, one that is high in sphericity is preferred. If the incorporated amount of the fused spherical silica (D) is less than 88% by weight, it is impossible to inhibit a molded article from warping; on the other hand, if it is incorporated in an amount larger than 92% by weight, it is difficult to give flowability to the composition.

In the present invention, the fused spherical silica (D) is preferably one which containes 5 to 40% by weight of fused spherical silica with an average particle diameter of 0.2 to 5 µm. The filled amount of the fused spherical silica (D) can be increased while inhibiting the composition from increasing in viscosity when the fused spherical silica (D) contains the fused spherical silica with an average particle diameter of 0.2 to 5 µm in an amount of 5 to 40% by weight, more preferably 10 to 30% by weight, in the whole portion of the fused spherical silica (D).

Moreover, regarding the fused spherical silica (D), a fused spherical silica whose surface has been treated in advance with a silane coupling agent can also be used.

To the composition of the present invention can be further added silicone gel or silicone oil (E). The silicone gel, which is per se a known substance, has a polysiloxane structure and is produced by a condensation reaction process or an addition reaction process. The silicone oil, which is per se a known substance, also has a polysiloxane structure and is of a linear structure having about 2000 or less siloxane bonds. Their production methods are known and they can be obtained by, for example, the production methods disclosed in JP 54-48720 A, JP 48-17847 A, and the like. Specifically, they can be obtained, for example, by making an SiH group-containing siloxane in a relative amount of 0.3 to 0.8 mole react with one mole of vinyl group-containing organopolysiloxane in the presence of a platinum compound as a catalyst. The incorporated amount of the silicone gel or silicone oil (E) is preferably 5 to 100 parts by weight, more preferably 10 to 80 parts by weight relative to 100 parts by weight of the epoxy resin (A).

When using the silicone gel or silicone oil (E), it is preferable to incorporate it together with a dispersing agent (F) for dispersing it in an epoxy resin uniformly. Preferred examples of the dispersing agent include organopolysiloxane derivatives having a structure represented by the following formula (1) in their molecules.

-[-B-A-B-(C-D)n-C-]p- (1)

In the formula (1), A represents a residue of an organopolysiloxane compound that has active hydrogen-containing groups at both ends and has 20 to 50 siloxane bonds, B represents a residue of a bifunctional organic compound that has two functional groups capable of reacting with active hydrogen wherein the compound is selected from among a biphenyl or naphthalene skeleton-containing epoxy compound, a diisocyanate compound and a dicarboxylic acid compound, C represents a residue of a bifunctional organic compound that have two active hydrogen-containing groups wherein the residue is a residue of a bisphenol compound capable of reacting with an epoxy, a residue of a glycol compound capable of reacting with a diisocyanate compound, or a residue of a diamino compound capable of reacting with a dicarboxylic acid compound, D represents a residue of a bifunctional organic compound that have two functional groups capable of reacting with active hydrogen, n represents an integer of 1 to 20, and p represents an integer of 1 to 20. Such organopolysiloxane derivatives are suitable as a dispersing agent for dispersing silicone gel or silicone oil in an epoxy resin because they contain both an organopolysiloxane chain and an aromatic ring-containing chain or a long-chain aliphatic chain.

Regarding the organopolysiloxane derivative, the residue B and the residue D in the formula (1) may be the same compound residue, and in that case the derivative can have a structure represented by the following formula (2).

-[-B-A-B-(C-B)n-C-]p- (2)

In the formula (2), A represents a residue of an organopolysiloxane compound that has active hydrogen-containing groups at both ends and has 20 to 50 siloxane bonds, B represents a bifunctional aromatic epoxy compound residue represented by the formula (3).

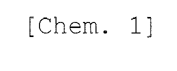

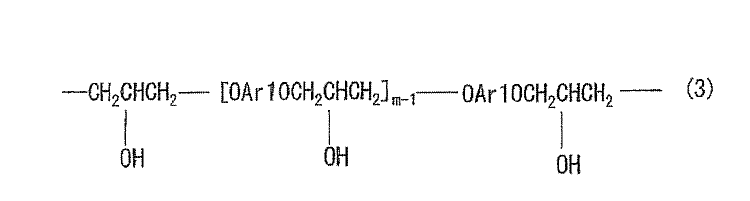

In the formula (3), Ar1 represents a divalent aromatic group derived from biphenyl or naphthalene, and m represents an integer of 1 or 2, C represents a dihydric phenol compound residue represented by -O-Ar2-O- wherein Ar2 represents a 2,2-bisphenylpropyl group, n represents an integer of 1 to 20, and p represents an integer of 1 to 20.

The production method of the polysiloxane derivatives is known and, for example, the method disclosed in the publication of Japanese Patent No. 3855074 can be used. Moreover, specific examples of the polysiloxane derivative as a preferable dispersing agent are also disclosed in Example 1 (dispersing agent B) and Example 5 (dispersing agent C) of the above-mentioned publication. In an exemplary production method, phenol-terminated silicone oil and a naphthalene skeletal type diglycidyl ether are made react together and then bisphenol A diglycidyl ether and bisphenol A are polymerized to the reaction product. By doing so, it is possible to obtain a dispersing agent that has a polyether structure and has epoxy groups at the ends thereof.

The incorporated amount of the dispersing agent (F) may be any amount that is necessary for dispersing the silicone gel or silicone oil (E) in a resin; for example, when using the above-mentioned organopolysiloxane derivative, the amount is preferably 5 to 80 parts by weight, more preferably 10 to 50 parts by weight relative to 100 parts by weight of the silicone oil or a silicone gel.

For the composition of the present invention can be used other additives unless the object of the present invention is impaired. Such additives include a silane coupling agent, carbon black, and so on. Examples of the silane coupling agent include γ-glycidoxypropyltrimethoxysilane, γ-glycidoxypropyltriethoxysilane, β-(3,4-epoxycyclohexyl)ethyltrimethoxysilane, β-(3,4-epoxycyclohexyl)ethyltriethoxysilane, vinyltrimethoxysilane, and vinyltriethoxysilane. The silane coupling agent may be incorporated if desired even in the event of using fused spherical silica to the surface of which a silane coupling agent has been made react in advance.

The incorporated amount of the silane coupling agent is preferably 0.1 to 10 phr, more preferably 2 to 6 phr in the composition.
The incorporated amount of the carbon black is preferably 0.1 to 5 phr, more preferably 0.5 to 3 phr in the composition.

The composition of the present invention can be prepared by mixing the above-mentioned components by a conventional method. In the present invention, no organic solvent is used because the use of volatile components is to be avoided.

The composition of the present invention has a viscosity of 1000 Pa·s or lower at 25°C under a shear rate of 2.5 (1/s). The viscosity is a value measured by an HBT type viscometer manufactured by Brookfield Engineering Labs, Inc. if the value varies depending upon measuring methods. If the composition has a viscosity exceeding 1000 Pa.s, it easily causes wire sweep or defective filling at the time of compression molding, and resin supply will become difficult at the time of production.

As curing conditions for the composition of the present invention, a temperature of 50 to 200°C can be used preferably, more preferably, a temperature of 100 to 175°C and a period of about 2 to about 10 minutes can be used.

The composition of the present invention is a composition for encapsulating electronic parts. An example of the method of use of the composition is such a method that the encapsulation of an electronic parts, preferably the encapsulation of a large-area semiconductor package, is performed by a compression molding method. The compression molding method can be performed by using a known compression molding machine, or the like.

The present invention will be explained below in more detail by providing examples, but the present invention is not limited thereto.

Examples 1 to 13 and Comparative Examples 1 to 11
Respective compositions were obtained by blending the ingredients in the incorporated amounts (parts by weight) given in Tables 1, 2 and 3 and mixing them well at room temperature. For each of the compositions obtained, the viscosity at 25°C under a shear rate of 2.5 (1/s) was measured by an HBT type viscometer manufactured by Brookfield Engineering Labs, Inc. The viscosity increase ratio was determined as a rate of increase (%) of the viscosity by measuring the viscosity of a resulting composition after 24 hours standing at 25°C. However, if a composition is high in initial viscosity and in a putty-like state, its viscosity increase ratio cannot be determined. The viscosity increase ratio of an accelerator will be described later. The filling ratio of a filler represents the filling ratio of fused spherical silica.

Next, the respective compositions were molded by a compression molding method, with a cavity of 100 × 100 × 0.3 mm on an FR-4 circuit board (120 × 120 × 0.4 mm) at 150°C for 3 minutes in Examples 1 to 9 and Comparative Examples 1 to 9, and with a cavity diameter of 200 mm and a cavity height of 0.4 mm on a silicon wafer (200 mm in diameter and 0.7 mm in thickness) at 120°C for 10 minutes in Examples 10 to 13 and Comparative Examples 10 and 11. For molded articles, the mold releasability and the fillability were evaluated by the following methods.

Moreover, the Tg of a molded article was measured by a DMA method. While the measurement conditions were set at a temperature increase rate of 2°C/min and a frequency of 1 Hz, the temperature of a first peak of tan δ was determined. Furthermore, a molded article was subjected to post curing at 150°C for 1 hour, and the Tg of the cured article was measured by the DMA method. While the measurement conditions were set at a temperature increase rate of 2°C/min and a frequency of 1 Hz, the temperature of a peak of tan δ was determined. For cured articles, warpage was evaluated by the following methods. These results are given in Tables 1, 2, and 3.

### Evaluation methods

### (1) Mold releasability

In Examples 1 to 9 and Comparative Examples 1 to 9, evaluation was performed according to the following criteria after compression molding done at 150°C for 3 minutes.
○ (Good) : The release film exhibits good releasability and can be removed from a mold.
× (Poor) : The resin fails to cure or deforms at the time of releasing from a mold, so that it can not be removed from the mold.
In Examples 10 to 13 and Comparative Examples 10 and 11, evaluation was performed according to the following criteria after compression molding done at 120°C for 10 minutes.
○ (Good) : The release film exhibits good releasability and can be removed from a mold.
× (Poor) : The resin fails to cure or deforms at the time of releasing from a mold, so that it can not be removed from the mold.

### (2) Fillability (appearance) A

In Examples 1 to 9 and Comparative Examples 1 to 9, evaluation was performed according to the following criteria after compression molding done at 150°C for 3 minutes.
○ (Good) : A cavity (100 × 100 × 0.3 mm) has been filled up with a resin and the appearance of a molded article has no defects.
× (Poor): Curing started in the middle of molding, and part of a cavity (100 × 100 × 0.3 mm) has remained unfilled with a resin, so that a molded article has defects in appearance caused by defective molding.

### (3) Fillability (appearance) B

In Examples 10 to 13 and Comparative Examples 10 and 11, evaluation was performed according to the following criteria after compression molding done at 120°C for 10 minutes. It is noted that in Comparative Example 10, fillability (appearance) B was not evaluated because the composition was high in initial viscosity and in a putty-like state.
⊚ (Very good) : A cavity (200 mm in diameter × 0.4 mm in cavity height) has been filled up with a resin, and the molded article has no defects in its appearance from the internal circumference to the outer periphery of a wafer.
○ (Good): Although a cavity (200 mm in diameter × 0.4 mm in cavity height) has been filled up with a resin, a flow mark has occurred in a wafer outer peripheral part.
× (Poor): Curing started in the middle of molding, and part of a cavity (200 mm in diameter × 0.4 mm in cavity height) has remained unfilled with a resin, so that a molded article has defects in appearance caused by defective molding.
Moreover, when the fillability (appearance) B was evaluated similarly by using the compositions of Examples 1 to 9, the results were all "○ (Good)"

### (4) Warpage A

In Examples 1 to 9 and Comparative Examples 1 to 9, evaluation was performed according to the following criteria by the following method after compression molding done at 150°C for 3 minutes.
After molding, the circuit board side of a package having been subjected to post curing was measured and the amount of warpage was evaluated according to the following criteria. Regarding the measuring method, the average of the differences of height between the central part and four corners were measured by using a laser displacement meter, and the value was regarded as the amount of warpage.
⊚ (Very good): Less than 100 µm
○ (Good): Not less than 100 µm and less than 500 µm
× (Poor): Not less than 500 µm

### (5) Warpage B

In Examples 10 to 13 and Comparative Examples 10 and 11, evaluation was performed according to the following criteria by the following method after compression molding done at 120°C for 10 minutes. It is noted that in Comparative Example 10, warpage B was not evaluated because the composition was high in initial viscosity and in a putty-like state.
After molding, the circuit board side of a silicon wafer having been subjected to post curing was measured and the amount of warpage was evaluated according to the following criteria. Regarding the measuring method, the average of the differences of height between the central part and points located on four peripheral parts at equal intervals was measured by using a laser displacement meter, and the value was regarded as the amount of warpage.
⊚ (Very good): Less than 5 mm
○ (Good): Not less than 5 mm and less than 15 mm
× (Poor): Not less than 15 m
Moreover, when the warpage B was evaluated similarly by using the compositions of Examples 1 to 9, the results were all "O (Good) "

The meanings of the abbreviations in each table are as follows. Regarding the viscosity increase ratio of an accelerator, a viscosity increase ratio at 25°C after 24 hours standing of a mixture of 10 parts by weight of the accelerator, 100 parts by weight of an epoxy resin (1), and 100 parts by weight of methyltetrahydroxy acid anhydride was measured by using an HBT type viscometer manufactured by Brookfield Engineering Labs, Inc.
Epoxy resin (1): bisphenol A type epoxy resin (190 g/eq in epoxy equivalent)
Epoxy resin (2) : alicyclic epoxy resin (135 g/eq in epoxy equivalent)
Acid anhydride (1): methyltetrahydroxy acid anhydride (164 g/eq in acid anhydride equivalent)
Fused spherical silica (1): 10 µm in average particle diameter
Fused spherical silica (2): 8 µm in average particle diameter (resulting from 15% incorporation of fused spherical silica with an average particle diameter of 2 µm to fused spherical silica (1))
Fused spherical silica (3): 35 µm in average particle diameter
Fused spherical silica (4): 30 µm in average particle diameter (resulting from 15% incorporation of fused spherical silica with an average particle diameter of 2 µm to fused spherical silica (3))
Silane coupling agent:
3-glycidoxypropyltrimethoxysilane
   Accelerator (1) : curing accelerator of the microcapsule type (1) (produced by Asahi Kasei Corporation) (1.2 times in viscosity increase ratio)
   Accelerator (2): curing accelerator of the microcapsule type (2) (produced by Nippon Kayaku Co., Ltd.) (2.2 times in viscosity increase ratio)
   Accelerator (3): 2-methylimidazole
   Accelerator (4): curing accelerator of the microcapsule type (3) (produced by Asahi Kasei Corporation) (1.3 times in viscosity increase ratio)
   Accelerator (5): curing accelerator of the microcapsule type (4) (produced by Asahi Kasei Corporation) (1.2 times in viscosity increase ratio)
   Organopolysiloxane derivative: a product having epoxy groups at its both ends and having a weight average molecular weight of 23000 obtained by making react together 100 parts by weight of phenol-terminated polydimethylsiloxane (1500 in phenol equivalent, 100 mPa·s in viscosity at 25°C), 65 parts by weight of naphthalene skeletal type diglycidyl ether (142 in epoxy equivalent), 0.03 parts by weight of tetramethylammonium chloride, and 34 parts by weight of bisphenol A.
   Silicone gel: two-component type silicone gel TSE3062 (produced by GE Toshiba Silicones Co., Ltd.)
   Silicone oil: epoxy group-containing silicone oil (1200 in epoxy equivalent, 700 mPa·s in viscosity at 25°C)

**[Table 1]**

| | Example 1 | Example 2 | Example 3 | Example 4 | Example 5 | Example 6 | Example 7 | Example 8 | Example 9 |
|---|---|---|---|---|---|---|---|---|---|
| Epoxy resin (1) | 70 | 70 | 70 | 70 | 70 | 70 | 70 | 70 | 70 |
| Epoxy resin (2) | 30 | 30 | 30 | 30 | 30 | 30 | 30 | 30 | 30 |
| Acid anhydride (1) | 100 | 100 | 100 | 100 | 100 | 100 | 100 | 100 | 100 |
| Fused spherical silica (3) | 1570 | 1640 | - | 1570 | 1640 | - | 1570 | 1640 | - |
| Fused spherical silica (4) | - | - | 1920 | - | - | 1920 | - | - | 1920 |
| Silane coupling agent | 3 | 3 | 3 | 3 | 3 | 3 | 3 | 3 | 3 |
| Carbon black | 1 | 1 | 1 | 1 | 1 | 1 | 1 | 1 | 1 |
| Accelerator (1) | 10 | 20 | 10 | - | - | - | - | - | - |
| Accelerator (4) | - | - | - | 10 | 20 | 10 | - | - | - |
| Accelerator (5) | - | - | - | - | - | - | 10 | 20 | 10 |
| Total | 1784 | 1864 | 2134 | 1784 | 1864 | 2134 | 1784 | 1864 | 2134 |
| Filling ratio of filler | 88.0% | 88.0% | 90.0% | 88.0% | 88.0% | 90.0% | 88.0% | 88.0% | 90.0% |
| Viscosity (initial) | 400 | 400 | 500 | 400 | 400 | 500 | 400 | 400 | 500 |
| Viscosity increase ratio (time(s)) | 1.4 | 1.4 | 1.5 | 1.4 | 1.4 | 1.5 | 1.4 | 1.4 | 1.5 |
| Tg after molding | 140 | 145 | 140 | 145 | 145 | 150 | 145 | 145 | 150 |
| Mold Releasability | Good | Good | Good | Good | Good | Good | Good | Good | Good |
| Fillability (appearance) A | Good | Good | Good | Good | Good | Good | Good | Good | Good |
| Tg after post curing | 150 | 145 | 150 | 150 | 145 | 150 | 150 | 145 | 150 |
| Warpage A | Good | Good | Very good | Good | Good | Very good | Good | Good | Very good |

**[Table 2]**

| | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|
| Epoxy resin (1) | 70 | 70 | 70 | 70 | 70 | 70 | 70 | 70 | 70 |
| Epoxy resin (2) | 30 | 30 | 30 | 30 | 30 | 30 | 30 | 30 | 30 |
| Acid anhydride (1) | 100 | 100 | 100 | 100 | 100 | 100 | 100 | 100 | 100 |
| Fused spherical silica (1) | 1530 | - | - | - | - | - | - | - | - |
| Fused spherical silica (2) | - | 1530 | 950 | 975 | 1020 | - | - | - | - |
| Fused spherical silica (3) | - | - | - | - | - | 1520 | 1870 | 1570 | 1510 |
| Silane coupling agent | 3 | 3 | 3 | 3 | 3 | 3 | 3 | 3 | 3 |
| Carbon black | 1 | 1 | 1 | 1 | 1 | 1 | 1 | 1 | 1 |
| Accelerator (1) | 5 | 5 | 5 | 10 | 20 | 3 | 50 | - | - |
| Accelerator (2) | - | - | - | - | - | - | - | 10 | - |
| Accelerator (3) | - | - | - | - | - | - | - | - | 2 |
| Total | 1739 | 1739 | 1159 | 1189 | 1244 | 1727 | 2124 | 1784 | 1716 |
| Filling ratio of filler | 88.0% | 88.0% | 82.0% | 82.0% | 82.0% | 88.0% | 88.0% | 88.0% | 88.0% |
| Viscosity (initial) | Putty | Putty | 150 | 150 | 150 | 400 | 450 | 400 | 500 |
| Viscosity increase ratio (time(s)) | - | - | 1.4 | 1.4 | 1.4 | 1.4 | 1.4 | 2.4 | 3.2 |
| Tg after molding | 100 | 100 | 100 | 140 | 140 | 100 | 140 | 140 | 145 |
| Mold Releasability | Poor | Poor | Poor | Good | Good | Poor | Good | Good | Good |
| Filling nature (appearance) A | Good | Good | Good | Good | Good | Good | Poor | Poor | Poor |
| Tg after post curing | 150 | 150 | 150 | 145 | 140 | 150 | 140 | 150 | 150 |
| Warpage A | Good | Good | Poor | Poor | Poor | Good | Good | Good | Good |

**[Table 3]**

| | Example 10 | Example 11 | Example 12 | Example 13 | Comparative Example 10 | Comparative Example 11 |
|---|---|---|---|---|---|---|
| Epoxy resin (1) | 70 | 70 | 70 | 70 | 70 | 70 |
| Epoxy resin (2) | 30 | 30 | 30 | 30 | 30 | 30 |
| Acid anhydride (1) | 100 | 100 | 100 | 100 | 100 | 100 |
| Organopolysiloxane derivative | 3 | 6 | 5 | 10 | 3 | 3 |
| Silicone gel | 14 | 28 | - | - | 14 | 14 |
| Silicone oil | - | - | 20 | 40 | - | - |
| Fused spherical silica (2) | - | - | - | - | 1660 | - |
| Fused spherical silica (3) | - | - | - | - | - | 1690 |
| Fused spherical silica (4) | 1770 | 1890 | 1830 | 2000 | - | - |
| Silane coupling agent | 3 | 3 | 3 | 3 | 3 | 3 |
| Carbon black | 1 | 1 | 1 | 1 | 1 | 1 |
| Accelerator (1) | 20 | 20 | 20 | 20 | 5 | - |
| Accelerator (2) | - | - | - | - | - | 10 |
| Total | 2011 | 2148 | 2079 | 2274 | 1886 | 1921 |
| Filling ratio of filler | 88.0% | 88.0% | 88.0% | 88.0% | 88.0% | 88.0% |
| Viscosity (initial) | 750 | 950 | 300 | 400 | Putty | 900 |
| Viscosity increase ratio (time(s)) | 1.5 | 1.5 | 1.4 | 1.5 | - | 2.8 |
| Tg after molding | 150 | 150 | 145 | 145 | 100 | 140 |
| Mold Releasability | Good | Good | Good | Good | Poor | Good |
| Fillability (appearance) A | Good | Good | Good | Good | Good | Poor |
| Tg after post curing | 150 | 150 | 145 | 145 | 150 | 150 |
| Warpage A | Very good | Very good | Very good | Very good | Good | Good |
| Fillability (appearance) B | Very good | Very good | Very good | Very good | - | Poor |
| Warpage B | Very good | Very good | Very good | Very good | - | Very good |

From the examples provided above, it was found that the compositions of the present invention exhibited a liquid form at room temperature in spite of the inclusion of a filler in a high filling ratio, reconciled reactivity with storage stability, excelled in, for example, mold releasability and fillability into a cavity, and were inhibited from warping. Especially, package molding on a silicon wafer was extremely good in the case of the use of silicone gel or silicone oil together with a suitable dispersing agent (Examples 10 to 13). On the other hand, regarding the compositions of the comparative examples, they were no longer in a liquid form when a filler was highly filled (Comparative Examples 1 and 2); the amount of warpage increased as the flowability of a composition was increased by saving the filling amount (Comparative Examples 3, 4, and 5); fillability into a cavity was deteriorated when the content of a curing accelerator was excessively large (Comparative Example 7); and it was impossible to reconcile reactivity with storage stability and fillability into a cavity was deteriorated when the viscosity increase ratio of a curing accelerator was excessively large (Comparative Examples 8 and 11). Moreover, when the content of a curing accelerator was excessively small, the Tg after molding was low and the release from a mold was impossible (Comparative Examples 1 to 3, and 6). When a curing accelerator that is not a capsule type curing accelerator was used, the viscosity increase ratio of a composition became high (Comparative Example 9).

## Claims

1. An epoxy resin composition for encapsulating electronic parts, comprising:
(A) 100 parts by weight of an epoxy resin,
(B) 50 to 150 parts by weight of an acid anhydride,
(C) 8 to 40 parts by weight of a curing accelerator of the microcapsule-type which satisfies the following: the viscosity increase ratio after 24 hours standing at 25°C of a mixture of 10 parts by weight of the curing accelerator, 100 parts by weight of the epoxy resin (A), and 100 parts by weight of methyltetrahydroxy acid anhydride as the acid anhydride (B) is 1.0 to 2.0 times, and
(D) fused spherical silica with an average particle diameter of 20 to 40 µm in an amount of 88 to 92% by weight of the composition,
wherein the viscosity of the composition at 25°C under a shear rate of 2.5 (1/s) is 1000 Pa·s or lower.

2. The composition according to claim 1, wherein the fused spherical silica (D) with an average particle diameter of 20 to 40 µm contains fused spherical silica with an average particle diameter of 0.2 to 5 µm in an amount of 5 to 40% by weight.

3. The composition according to claim 1 or 2, further comprising (E) silicone gel or silicone oil in an amount of 5 to 100 parts by weight relative to 100 parts by weight of the epoxy resin (A), and (F) a dispersing agent.

4. The composition according to claim 3, wherein the dispersing agent (F) is an organopolysiloxane derivative having in its molecule a structure represented by the following formula (1) :
-[-B-A-B-(C-D)n-C-]p- (1)
wherein A represents a residue of an organopolysiloxane compound that has active hydrogen-containing groups at both ends and has 20 to 50 siloxane bonds, B represents a residue of a bifunctional organic compound that has two functional groups capable of reacting with active hydrogen wherein the compound is selected from among a biphenyl or naphthalene skeleton-containing epoxy compound, a diisocyanate compound and a dicarboxylic acid compound, C represents a residue of a bifunctional organic compound that has two active hydrogen-containing groups wherein the residue is a residue of a bisphenol compound capable of reacting with an epoxy compound, a residue of a glycol compound capable of reacting with a diisocyanate compound, or a residue of a diamino compound capable of reacting with a dicarboxylic acid compound, D represents a residue of a bifunctional organic compound that has two functional groups capable of reacting with active hydrogen, n represents an integer of 1 to 20, and p represents an integer of 1 to 20.
